(19) Europäisches Patentamt
European Patent Office
Office européen des brevets

(11) **EP 2 099 264 A1**

(12) **DEMANDE DE BREVET EUROPEEN**

(43) Date de publication:
**09.09.2009 Bulletin 2009/37**

(51) Int Cl.:
***H05K 1/02*** *(2006.01)*

(21) Numéro de dépôt: **08152224.5**

(22) Date de dépôt: **03.03.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(71) Demandeur: **Delphi Technologies, Inc.**
**Troy, Michigan 48007 (US)**

(72) Inventeur: **Kebir, Abdelmoneim**
**93350, Le Bourget (FR)**

(74) Mandataire: **Vigand, Philippe**
**William Blanc & Cie**
**Avenue de Pailly 25**
**1220 Les Avanchets-Genève (CH)**

(54) **Plaquette à circuit imprimé avec thermocouple**

(57) L'invention concerne un circuit imprimé (1) comprenant un support formé par au moins deux couches externes composées d'une couche supérieure (C1) et d'une couche inférieure (C2), une pluralité de composants électroniques agencés sur le support, un circuit de surveillance (C3, C4, 4) de la température du circuit imprimé pour détecter un dépassement d'un seuil prédéterminé de température de surchauffe du circuit imprimé, **caractérisé en ce que** le circuit de surveillance comprend au moins une couche conductrice intérieure (C3, C4) disposée entre les couches externes et un dispositif de mesure de la force électromotrice générée par une variation de température dans ladite au moins une couche conductrice intérieure et des moyens de corrélation (4) entre la force électromotrice mesurée et le seuil prédéterminé de température de surchauffe.

**Fig. 3b**

# Description

## DOMAINE TECHNIQUE

L'invention concerne de manière générale un système de protection électrique contre la surchauffe d'un circuit électronique, et plus particulièrement, un système de détection d'une telle surchauffe. Cette invention est applicable dans le cadre de la protection électrique et contre les départs d'incendie provoqués par une dérive fonctionnelle de tout ou partie d'un équipement comprenant un circuit électronique et faisant intervenir une énergie (électrique, thermique, magnétique, chimique...).

En particulier, la présente invention a pour but de prévenir les départs d'incendies provoqués par la surchauffe des éléments ou composants constituant une carte électronique ou circuit imprimé. Les départs d'incendie concernés sont essentiellement ceux liés à une inflammation par flamme ou à l'atteinte du point d'auto inflammation d'un matériau constituant un équipement en contact avec une source de chaleur maintenue, ou en raison d'un disfonctionnement lié à un court-circuit franc ou aggravé, à une surcharge électrique...

## ARRIERE-PLAN TECHNOLOGIQUE

Il est connu dans l'art antérieur de nombreux systèmes de protection contre la surchauffe de circuit électronique. En particulier, le document US 2007/090870 décrit un circuit intégré comprenant plusieurs éléments de circuit dont chacun est pourvu d'un circuit de test ayant des valeurs et des variations d'élément identiques à l'élément de circuit correspondant, au moins un élément de circuit de référence ayant une plus petite variation que l'élément de circuit correspondant; un comparateur qui obtient une différence entre les intensités des signaux détectés à partir du circuit de test, et une unité d'accord qui accorde la variation de l'élément de circuit correspondant selon la différence entre les intensités desdits signaux. Ainsi, les variations de la température d'un élément de circuit peuvent être détectées et accordées en ce qui concerne cet élément de circuit.

Il est également connu, en particulier du document US 2004/159904, un circuit intégré comprenant un circuit thermosensible ou circuit de détection de la température pour produire un signal indicatif de la température du substrat près du circuit thermosensible. Le circuit intégré comprend une circuiterie pour recevoir un signal du circuit thermosensible et pour convertir ce signal en un signal indicatif de la température du circuit intégré. Un circuit de commande thermique compare la température du circuit intégré à un seuil et produit un signal d'action de correction quand la température excède le seuil. Le signal d'action de correction est fourni à des circuits d'action de correction configurés pour modifier le fonctionnement du circuit intégré en vue de réduire la température du circuit intégré à proximité du circuit thermosensible correspondant. Ces circuits thermosensibles sont réalisés au moyen d'un nombre impair d'inverseurs CMOS connectés en série et dont le signal a une température dépendant de la fréquence.

Il est encore connu, en particulier du document US 2004/179576, des techniques pour empêcher un circuit intégré de surchauffer, visant à détecter si une température du circuit intégré excède un seuil de température d'un état de fonctionnement du circuit intégré, et à couper au moins une partie de la puissance fournie au circuit intégré si la température du circuit excède le seuil. Pour cela, le circuit intégré est équipé avec un capteur de température ou sonde thermique qui inclut un comparateur, une tension de référence couplée à une entrée du comparateur et fournie par une source de courant, et une diode thermique construite pour surveiller une température d'un substrat sous la forme d'une jonction PN.

Toutes ces solutions de l'art antérieur préconisent une protection d'une carte électronique par surveillance du comportement thermique, laquelle surveillance de l'ensemble d'une carte électronique d'un point de vue thermique nécessite la surveillance du comportement thermique de chaque composant ou élément posé sur le circuit imprimé. Pour cela les solutions de mesure de température existantes exposées en relation avec les documents de l'art antérieur, nécessitent une implantation des circuits de surveillance à proximité de chaque composant de la carte électronique. De telles solutions impactes de façon significative la conception d'une carte électronique avec de nombreux inconvénients parmi lesquels un plus grand encombrement du circuit intégré ou de la carte imprimée en termes de surface, de poids et de volume, ainsi qu'une consommation électrique accrue, ce qui peut s'avérer très dommageable notamment pour les systèmes embarqués, une sûreté de fonctionnement et une fiabilité de détection incertaine dans la mesure où les disfonctionnements peuvent endommagés les circuits de test eux-mêmes, une complexité accrue d'interprétation des mesures et d'unité de traitement et bien entendu une répercussion importante sur le coût de fabrication d'un tel système intégré de protection contre les variations de température.

## RESUME DE L'INVENTION

Un but de la présente invention est de répondre aux inconvénients mentionnés ci-dessus en fournissant un circuit imprimé muni d'un dispositif de détection d'une surchauffe des éléments constituant le circuit, ce dispositif de détection devant être simple et fiable.

Dans ce but, un premier aspect de la présente invention concerne un circuit imprimé comprenant un support formé par au moins deux couches externes composées d'une couche supérieure et d'une couche inférieure, une pluralité de composants électroniques agencés sur le support, un circuit de surveillance de la température du circuit imprimé pour détecter un dépassement d'un seuil prédéterminé de température de surchauffe du circuit imprimé, **caractérisé en ce que** le circuit de surveillance comprend au moins une couche conductrice intérieure disposée entre les couches externes et un dispositif de mesure de la force électromotrice générée par une variation de température dans ladite au moins une couche conductrice intérieure et des moyens de corrélation entre la force électromotrice mesurée et le seuil prédéterminé de température de surchauffe.

L'adjonction d'au moins une couche métallique supplémentaire à l'intérieur du circuit imprimé constitue un thermocouple placé au plus près des composants du circuit ayant pour effet de permettre de connaître de façon instantanée la température la plus élevée en surface du circuit imprimé et cela même à des températures très élevées.

Selon un premier mode de réalisation avantageux, le circuit de surveillance comprend deux couches conductrices intérieures reliées par au moins deux jonctions et formant un thermocouple et en ce que le dispositif de mesure de la force électromotrice est un dispositif de mesure d'une différence de potentiel entre les deux jonctions. Une telle solution présente l'avantage de pouvoir choisir facilement les propriétés du thermocouple, en particulier le domaine de température le plus efficace suivant les conditions d'utilisation et les propriétés du circuit imprimé.

Selon une variante avantageuse, les moyens de corrélation comprennent un comparateur entre la différence de potentiel mesurée entre les deux jonctions et un seuil de tension prédéfini correspondant à la différence de potentiel calculée pour la température de surchauffe.

Selon une autre variante avantageuse, le circuit imprimé comprend quatre couches externes isolées électriquement entre elles et avec les couches conductrices intérieures de manière à accroître la surface d'intégration disponible sur le circuit imprimé.

Selon une autre variante avantageuse, le thermocouple est une cellule de Peltier.

Selon un autre mode de réalisation avantageux, le circuit de surveillance comprend une seule couche conductrice intérieure traversée par un courant électrique et le dispositif de mesure de la force électromotrice est un dispositif de mesure d'un gradient de flux thermique entre deux points de la couche conductrice intérieure. Une telle solution présente l'avantage de ne nécessiter qu'une seule couche additionnelle, ce qui rend sa réalisation moins complexe et moins coûteuse tout en réduisant l'épaisseur totale du circuit imprimé.

Selon une variante avantageuse selon l'un des deux modes précédents, le circuit imprimé comprend un circuit de protection actionné en cas de dépassement du seuil de température de surchauffe, ce circuit de protection comprenant une unité limiteur pour pouvoir limiter la puissance d'alimentation électrique du circuit.

Selon une autre variante avantageuse, le circuit imprimé comprend un circuit de protection actionné en cas de dépassement du seuil de température de surchauffe, ce circuit de protection comprenant une unité disjoncteur pour pouvoir déconnecter l'alimentation électrique du circuit. Une telle variante présente l'avantage de combiner un circuit de détection simple et fiable selon l'un des deux modes précédents avec un circuit de protection contre la surchauffe du circuit imprimé.

Selon un autre mode de réalisation, le support du circuit imprimé est subdivisé en plusieurs unités ou groupe d'unités fonctionnelles, et à chaque unité ou groupe d'unités fonctionnelles correspond un circuit de surveillance obtenu par subdivision des couches intérieures en un nombre correspondant de thermocouples. Ce mode de réalisation présente l'avantage de pouvoir détecter chaque unité ou groupe d'unités fonctionnelles défectueuses indépendamment. Avantageusement, chaque thermocouple est une cellule de Peltier.

Selon une autre variante avantageuse, le circuit comprend un circuit de protection pour chaque unité ou groupe d'unités fonctionnelles, actionné en cas de dépassement du seuil de température de surchauffe de l'unité ou du groupe d'unités fonctionnelles correspondant. Cette variante présente l'avantage de permettre de protéger uniquement les unités ou groupe d'unités fonctionnelles défectueuses.

Selon une autre variante avantageuse, le circuit de protection comprend une unité limiteur pour pouvoir limiter la puissance d'alimentation électrique de l'unité ou du groupe d'unités fonctionnelles correspondant.

Selon une autre variante avantageuse, le circuit de protection comprend une unité disjoncteur pour pouvoir déconnecter l'alimentation électrique de l'unité ou groupe d'unités fonctionnelles correspondant.

BREVE DESCRIPTION DES FIGURES

D'autres caractéristiques et avantages de la présente invention apparaîtront plus clairement à la lecture de la description détaillée qui suit de modes de réalisation de l'invention donnés à titre d'exemples nullement limitatifs et illustrés par les dessins annexés, dans lesquels :

- la figure 1 représente un circuit imprimé équipé d'un circuit de surveillance de la température selon un mode de réalisation préféré de la présente invention;

- la figure 2 représente un circuit de traitement lié au circuit de surveillance de la figure 1;

- les figures 3a et 3b représentent un circuit imprimé équipé d'un circuit de surveillance de la température selon un autre mode de réalisation de la présente invention;

- la figure 4 représente un circuit de traitement lié au circuit de surveillance des figures 3a et 3b;

- la figure 5 représente un circuit thermoélectrique de base pour exploiter l'effet thermoélectrique de Seebeck;

- la figure 6 représente un schéma de principe de l'effet thermoélectrique de Thomson;

DESCRIPTION DETAILLEE DE L'INVENTION

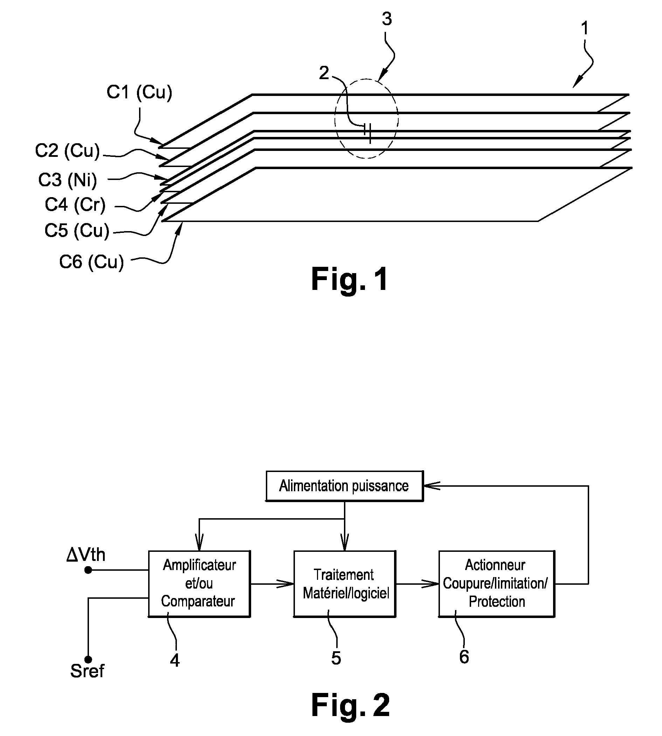

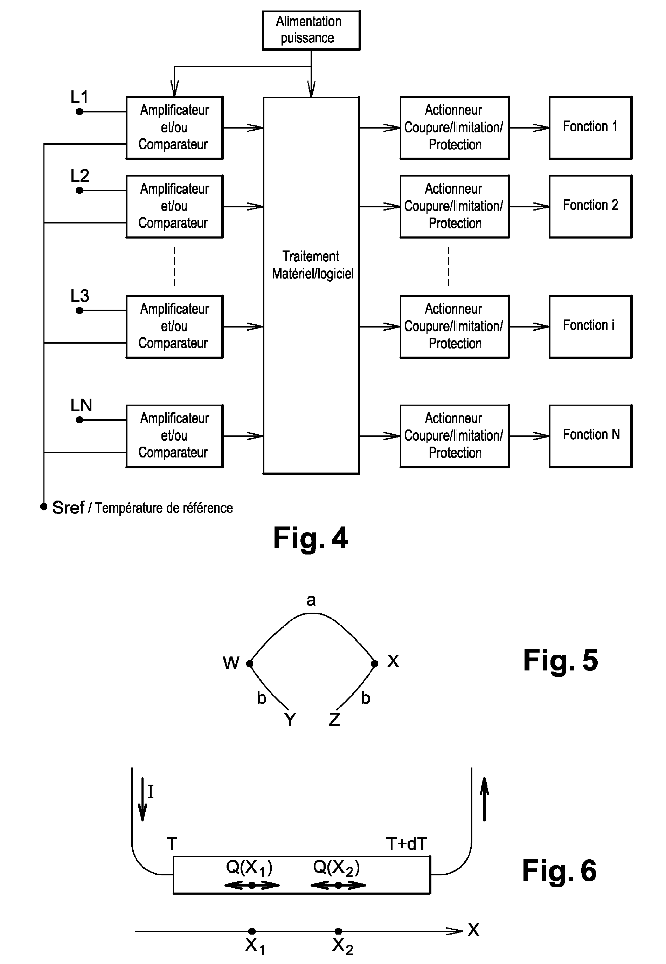

L'invention sera décrite ci-après uniquement à titre d'exemples non limitatifs en relation avec les figures 1 à 4. Les figures 5 et 6 sont donnés à titre explicatif des effets thermoélectriques de Seebeck et Thomson. Sur la figure 1, est représenté un circuit imprimé selon un premier mode de réalisation de l'invention.

Le circuit imprimé 1 comprend un support ou substrat multicouche sur lequel sont routées les pistes du circuit et disposés les différents composants électroniques (non représentés). Un tel substrat ou PCB, venant de la terminologie anglaise "Printed Circuit Board", comprend au moins deux couches conductrices externes, par exemple en Cuivre, composées d'une couche supérieure C1 et d'une couche inférieure C6. Elles sont isolées électriquement entre elles et avec les autres couches du circuit imprimé par des couches isolantes intermédiaires (non représentées), par exemple en matériau époxy. De préférence, pour des raisons de capacité d'intégration, le circuit imprimé est formé par quatre couches conductrices C1, C2, C5 et C6. Les couches conductrices intérieures formant le thermocouple ne sont en revanche pas isolées électriquement.

Dans le but de prévenir tout disfonctionnement du circuit imprimé lié à la surchauffe des éléments ou composants constituant le circuit imprimé, il est prévu de munir ce dernier d'un circuit de surveillance de la température pour détecter tout dépassement d'un seuil prédéterminé de température dit de "surchauffe" du circuit imprimé. Ce seuil est choisi de préférence comme la limite de température au-delà de laquelle tout point du circuit peut être endommagé et entraîné un disfonctionnement du circuit.

Selon le premier mode de réalisation présenté en liaison avec la figure 1, le circuit de surveillance est réalisé par l'adjonction de deux couches métalliques supplémentaires C3 et C4 constituant un couple thermoélectrique au niveau du circuit imprimé permettant de créer une cellule de Peltier/Seebeck placée au plus près de tous les composants du circuit imprimé, appelée encore carte électronique. Ces deux couches conductrices sont composées par exemple d'une couche de Nickel et d'une couche de Chrome et forment un thermocouple grâce à la présence de deux jonctions 2 réalisées entre ces deux couches.

Cela a pour effet de permettre de connaître de façon instantanée la température la plus élevée en surface du circuit imprimé et cela même à des températures très élevées suivant le thermocouple utilisé. Ainsi tout échauffement définit comme excessif sera détecté et traité par une unité de traitement permettant de convertir l'énergie thermique en énergie électrique, qui sera détaillée plus loin en liaison avec la figure 2.

Pour cela, le circuit de surveillance est basé sur la mesure de la force électromotrice 3 générée par la variation de température dans les couches conductrices intérieures C3 et C4 et sur des moyens de corrélation entre la force électromotrice mesurée et le seuil prédéterminé de température de surchauffe. Dans cet exemple représenté à la figure 1, les couches conductrices intérieures ont été choisies comme étant les couches médianes C3 et C4, il est toutefois envisageable de réaliser un circuit de surveillance sur la base de deux couches conductrices intérieures disposées au place C2 et C3, dans ce cas le PCB du circuit imprimé est alors formé par les couches C1, C4, C5 et C6, ou encore selon une autre variante, le circuit de surveillance peut regroupé les couches C4 et C5, le PCB comprenant alors les couches C1, C2, C3 et C6.

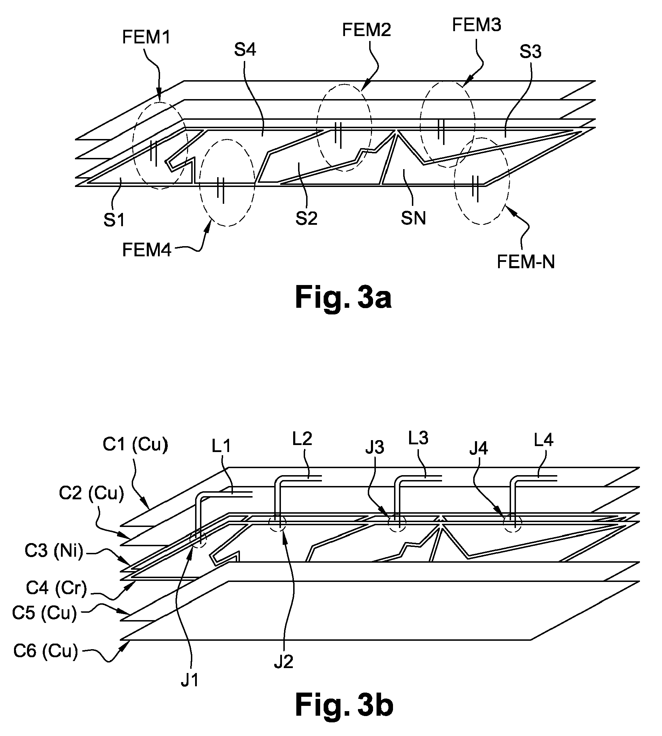

La figure 2 représente un circuit de traitement lié au circuit de surveillance du circuit imprimé représenté à la figure 1. Le principe consiste à convertir l'énergie thermique générée par le thermocouple en énergie électrique exploitable par le circuit de traitement. Pour cela, dans le cadre de la présente invention, un circuit de surveillance utilisant un effet thermoélectrique, comme par exemple l'effet Seebeck (figures 1 et 3a, 3b) ou à titre de variante l'effet Thomson, permet de recueillir une force électromotrice (FEM) générée par une variation de température (échauffement ou refroidissement) et/ou un gradient de température dans le thermocouple.

Ce signal représentatif de la force électromotrice est alors exploitable par un circuit de traitement de type matériel ou logiciel, pouvant ensuite actionner des circuits de protections adaptés.

Dans le cadre du premier mode de réalisation, présenté en relation la figure 1, la mesure de la force électromotrice 3 générée est définie par la différence de potentiel entre les deux jonctions des couches conductrices intérieures C3 et C4. A cet effet, les moyens de corrélation entre la force électromotrice mesurée et le seuil de température de surchauffe, comprennent un comparateur 4 entre la différence de potentiel ou thermocouple $\Delta Vth$ mesuré entre les deux jonctions et un seuil de référence Sref prédéfini représentatif de la différence de potentiel correspondant à une variation de température entre la température de fonctionnement normal et la température de surchauffe du circuit imprimé.

Ainsi tout échauffement définit comme excessif sera détecté à la sortie du comparateur 4 et transmis à une unité de traitement 5. Cette unité de traitement a pour but principal de commander l'actionnement d'un circuit de protection 6 en cas de dépassement du seuil prédéfini de température de surchauffe. Le principe de la protection contre un point chaud avéré, du à une source de chaleur entretenue et lié à un dysfonctionnement électrique (court-circuit franc, court-circuit aggravé dû à une impédance parasite, surcharge, etc.) peut être traité de plusieurs façons, soit par la limitation de puissance (stratégie de mode dégradé), soit par la coupure de l'arrivée d'énergie par déconnexion des alimentations 7 électriques correspondantes concernées. Ces deux solutions sont réalisées par exemple au moyen de relais électromécaniques ou de semi-conducteurs. Ainsi selon une première variante de réalisation, le circuit de protection comprend une unité limiteur pour pouvoir limiter la puissance d'alimentation électrique 7 du circuit et selon une deuxième variante le circuit de protection comprend une unité disjoncteur pour pouvoir déconnecter l'alimentation électrique 7 du circuit. Alternativement, le circuit de protection peut être une combinaison des deux variantes précédentes, l'unité limiteur étant activée suite au dépassement d'un premier seuil et l'unité disjoncteur étant activée suite au dépassement d'un deuxième seuil défini supérieur au premier seuil.

Le premier mode de réalisation exposé ci-dessus est donc basé sur l'utilisation d'une seule liaison réalisant la fonction thermocouple qui assure la surveillance du point le plus extrême thermiquement sur le PCB. Une telle solution présente un certain nombre d'avantages et permet en particulier l'utilisation d'une unité de traitement simple avec une stratégie de traitement également simple, i.e. limitation ou coupure de l'alimentation pour l'ensemble du circuit imprimé, ainsi qu'un circuit imprimé sans routage spécifique, i.e. thermocouple réalisé au moyen de couches brutes. Cela a en outre pour effet de réduite le coût de réalisation tout en assurant une grande fiabilité de fonctionnement.

A titre d'exemple avantageux selon le premier mode de réalisation, les couches conductrices intérieures forment un thermocouple Nickel / Chrome présentant un coefficient de Peltier de $68\mu$V / °Celsius. Ainsi pour une température de référence de fonctionnement du circuit fixée à 85 °C et un seuil de tolérance de 200°C, soit une température d'un point chaud fixée à 285°C, la différence de tension due à l'élévation de température pour un tel point chaud est de 200 * 68 = 13.6 mV.

En conséquence, l'utilisation par exemple d'un comparateur amplificateur à faible offset pour détecter une différence de tension de 14 mV permet de détecter toutes variations de température en tout point du circuit imprimé dépassant 200°C. Le seuil de détection est ajusté par l'unité de traitement selon les stratégies de protection répondant aux contraintes à satisfaire.

Les figures 3a et 3b représentent un circuit imprimé équipé d'un circuit de surveillance de la température selon un deuxième mode de réalisation de la présente invention. Tout d'abord, la figure 3a est une vue partielle représentant uniquement les couches supérieures et intérieures du circuit imprimé de manière à montrer clairement le routage appliqué sur le circuit de surveillance. Ensuite la figure 3b représente le circuit imprimé dans son ensemble sur lequel sont visibles les jonctions entre les couches conductrices intérieures formant les différents thermocouples.

Considérant la figure 3a, la partie supérieure du PCB est représentée. Elle comprend au moins une couche, dans cet exemple deux couches C1 et C2, ainsi que les couches conductrices intérieures C3 et C4 du circuit de surveillance. Dans ce mode de réalisation, il est prévu d'avoir la possibilité de localiser et protéger une fonction ou un groupe de fonctions du circuit imprimé défectueuses, tout en laissant les autres fonctions ou groupes de fonctions opérationnelles actives. Pour cela, les couches conductrices intérieures C3 et C4 sont divisées de sorte que plusieurs liaisons réalisent les fonctions thermocouples assurant la surveillance d'autant de points, thermiquement extrêmes, qu'il y a de fonctions ou groupes de fonctions à surveiller sur le PCB. Chaque subdivision S1, S2, ...SN forme donc un thermocouple permettant de surveiller la température d'une fonction ou groupe de fonctions du PCB par le biais de la mesure de la force électromotrice (FEM1, FEM2, ..., FEMN) générée entre le thermocouple et la fonction ou groupe de fonctions correspondant.

Considérant maintenant la figure 3b, les jonctions thermoélectriques J1, J2, ..., JN entre chacune des subdivisions S1, S2, ..., SN des deux couches conductrices intérieures C3 et C4 réalisant les différents thermocouples, sont représentées. Chacune de ces jonctions est connectée, via les liaisons L1, L2, ..., LN avec une unité de traitement intégrée sur le PCB de manière à pouvoir commander un circuit de protection correspondant à la fonction ou groupe de fonctions défectueuses.

La figure 4 représente le circuit de traitement lié au circuit imprimé selon le deuxième mode de réalisation présenté aux figures 3a et 3b. Chaque liaison L1, L2, ..., LN fournit une différence de potentiel représentative du point thermique le plus chaud de la subdivision correspondante et donc de la fonction ou groupe de fonctions correspondant, qui est comparée, au travers de comparateurs 41, 42, ..., 4n prévus à cet effet, à une tension représentative du seuil de tolérance de fonctionnement du circuit imprimé. Les résultats des différentes comparaisons effectuées sont traités dans une unité de traitement 5 consistant à déterminer quelles fonctions ou groupe de fonctions doit être protégées et à commander respectivement les circuits de protection liés à chaque fonction ou groupe de fonctions défectueuses. Les circuits de protection 61, 62, ..., 6n peuvent être selon une première variante des unités limiteur de puissance ou selon une deuxième variante des unités disjoncteur pour couper l'alimentation fournie à la fonction ou au groupe de fonctions correspondantes. Alternativement, le circuit de protection peut être une combinaison des deux variantes précédentes, l'unité limiteur étant activée suite au dépassement d'un premier seuil et l'unité disjoncteur étant activée suite au dépassement d'un deuxième seuil défini supérieur au premier seuil.

Le deuxième mode de réalisation exposé ci-dessus en relation avec les figures 3a-3b et 4, est donc basé sur l'utilisation de plusieurs liaisons qui réalisent les fonctions thermocouples assurant la surveillance d'autant de points, thermiquement extrêmes, qu'il y a de fonctions ou groupes de fonctions à surveiller sur le PCB. Une telle solution présente en particulier l'avantage de pouvoir localiser et protéger la ou les fonctions défectueuses tout en laissant les autres fonctions opérationnelles actives.

La figure 5 représente un circuit thermoélectrique de base pour exploiter l'effet thermoélectrique de Seebeck comme cela a été fait dans le cadre des deux premiers modes de réalisation détaillés précédemment.

Deux matériaux conducteurs de natures différentes a et b sont reliés par deux jonctions en X et W. Dans le cas de l'effet Seebeck, une différence de température dT est appliquée entre W et X, ce qui entraîne l'apparition d'une différence de potentiel dV entre Y et Z. En circuit ouvert, le coefficient Seebeck $S_{ab}$ du couple de matériaux, ou pouvoir thermoélectrique est défini par :

$$S_{ab} = \frac{dV}{dT}$$

Le coefficient Seebeck s'exprime en V.K-1, ou plus généralement en $\mu$V.K-1 au vu des valeurs de ce coefficient dans les matériaux usuels.

Selon un troisième mode de réalisation le circuit de surveillance du circuit imprimé comprend une seule couche conductrice intérieure traversée par un courant électrique et un dispositif de mesure d'un gradient de flux thermique entre deux points de la couche conductrice intérieure. Ce circuit de surveillance est basé sur le principe de l'effet thermoélectrique de Thomson représenté au moyen d'un schéma de principe à la figure 6.

La différence fondamentale entre les effets Seebeck et Peltier utilisés dans le cadre des deux premiers modes de réalisation et l'effet Thomson utilisé dans le cadre de ce troisième mode de réalisation est que ce dernier existe pour un seul matériau, i.e. une seule couche conductrice additionnelle étant suffisante, et ne nécessite donc pas la présence d'une jonction. L'effet Thomson est mis en évidence lorsque sont présents simultanément un gradient de température T et un courant électrique I à travers un matériau conducteur. Il y a alors génération ou absorption de chaleur Q dans chaque segment de matériau pris individuellement. Le gradient de flux thermique au sein du matériau est alors donné par :

$$\frac{dQ}{dx} = I \frac{dT}{dx} \tau$$

où x est la coordonnée spatiale et $\tau$ est le coefficient Thomson du matériau.

Ainsi, dans le cas de la mesure de gradient de température (Effet Thomson) une seule couche conductrice intérieure au PCB et parcourue par un courant électrique injecté, est nécessaire pour permettre de connaître de façon instantanée une différence de température en surface du circuit imprimé, même à des températures très élevées. Cette couche conductrice intérieure pourra par exemple être en Cuivre comme les couches formant le PCB.

On notera encore en liaison avec ce troisième mode de réalisation que l'on pourra utiliser de la même manière que dans le cadre des premier et deuxième modes de réalisation sus-décrits, un (cf. figure 2) ou respectivement plusieurs comparateurs (cf. figure 4) pour détecter par effet Thomson toute surchauffe du circuit imprimé ou respectivement d'une fonction ou groupe de fonctions du circuit imprimé, ainsi qu'un circuit de protection actionné par une unité de traitement pour protéger le circuit imprimé ou respectivement la fonction ou groupe de fonctions contre toute surchauffe détectée.

On comprendra que diverses modifications et / ou améliorations évidentes pour l'homme du métier peuvent être apportées aux différentes modes de réalisation de l'invention décrits dans la présente description sans sortir du cadre de l'invention défini par les revendications annexées. En particulier, on comprendra qu'il existe plusieurs types de thermocouples différents. Tous sont utilisés pour une gamme précise de température de quelques degrés à quelques milliers de degrés. Les signaux électriques de ces détecteurs thermiques sont de l'ordre du microvolt au millivolt. Les signaux sont traités par des modules électroniques intégrants une fonction adaptée au thermocouple. L'avantage de l'utilisation d'un tel thermocouple est sa fiabilité, son encombrement réduit et sa facilité de mise en oeuvre.

**Revendications**

**1.** Circuit imprimé (1) comprenant un support formé par au moins deux couches externes composées d'une couche supérieure (C1) et d'une couche inférieure (C2), une pluralité de composants électroniques agencés sur le support, un circuit de surveillance (C3, C4, 4) de la température du circuit imprimé pour détecter un dépassement d'un seuil prédéterminé de température de surchauffe du circuit imprimé, **caractérisé en ce que** le circuit de surveillance comprend au moins une couche conductrice intérieure (C3, C4) disposée entre les couches externes et un dispositif de mesure de la force électromotrice générée par une variation de température dans ladite au moins une couche conductrice intérieure et des moyens de corrélation (4) entre la force électromotrice mesurée et le seuil prédéterminé de température de surchauffe.

**2.** Circuit imprimé selon la revendication 1, **caractérisé en ce que** le circuit de surveillance comprend deux couches conductrices intérieures reliées par au moins deux jonctions (2) et formant un thermocouple et **en ce que** le dispositif de mesure de la force électromotrice est un dispositif de mesure d'une différence de potentiel entre les deux jonctions.

3. Circuit imprimé selon la revendication 2, **caractérisé en ce que** les moyens de corrélation comprennent un comparateur entre la différence de potentiel mesurée entre les deux jonctions et un seuil de tension prédéfini correspondant à la différence de potentiel calculée pour la température de surchauffe.

4. Circuit imprimé selon la revendication 2 ou 3, **caractérisé en ce qu'**il comprend quatre couches externes (C1-C2, C5-C6; C1, C4-C6; C1-C3; C6) isolées électriquement entre elles et avec les couches conductrices intérieures (C3-C4; C2-C3; C4-C5).

5. Circuit imprimé selon l'une des revendications 2 à 4, **caractérisée en ce que** le thermocouple est une cellule de Peltier.

6. Circuit imprimé selon la revendication 1, **caractérisé en ce que** le circuit de surveillance comprend une seule couche conductrice intérieure traversée par un courant électrique et **en ce que** le dispositif de mesure de la force électromotrice est un dispositif de mesure d'un gradient de flux thermique entre deux points de la couche conductrice intérieure.

7. Circuit imprimé selon l'une des revendications 1 à 6, **caractérisé en ce qu'**il comprend en outre un circuit de protection (6) actionné en cas de dépassement du seuil de température de surchauffe, ce circuit de protection comprenant une unité limiteur pour pouvoir limiter la puissance d'alimentation électrique du circuit.

8. Circuit imprimé selon l'une des revendications 1 à 6, **caractérisé en ce qu'**il comprend en outre un circuit de protection (6) actionné en cas de dépassement du seuil de température de surchauffe, ce circuit de protection comprenant une unité disjoncteur pour pouvoir déconnecter l'alimentation électrique du circuit.

9. Circuit imprimé selon l'une des revendications 2 à 4, dans lequel le support du circuit imprimé est subdivisé en plusieurs unités ou groupe d'unités fonctionnelles et **caractérisé en ce qu'**à chaque unité ou groupe d'unités fonctionnelles corresponde un circuit de surveillance obtenu par subdivision (S1, S2, ..., SN) des couches intérieures en un nombre correspondant de thermocouples (S1-J1, S2-J2, ..., SN-JN).

10. Circuit imprimé selon la revendication 9, **caractérisé en ce que** chaque thermocouple est une cellule de Peltier.

11. Circuit imprimé selon la revendication 9 ou 10, **caractérisé en ce qu'**il comprend en outre un circuit de protection (61, 62, ..., 6n) pour chaque unité ou groupe d'unités fonctionnelles, actionné en cas de dépassement du seuil de température de surchauffe de l'unité ou du groupe d'unités fonctionnelles correspondant.

12. Circuit imprimé selon la revendication 11, **caractérisé en ce que** le circuit de protection comprend une unité limiteur pour pouvoir limiter la puissance d'alimentation électrique de l'unité ou du groupe d'unités fonctionnelles correspondant.

13. Circuit imprimé selon la revendication 11, **caractérisé en ce que** le circuit de protection comprend une unité disjoncteur pour pouvoir déconnecter l'alimentation électrique de l'unité ou groupe d'unités fonctionnelles correspondant.

C1 (Cu)
C2 (Cu)
C3 (Ni)
C4 (Cr)
C5 (Cu)
C6 (Cu)

**Fig. 1**

Alimentation puissance

ΔVth

Amplificateur et/ou Comparateur

Traitement Matériel/logiciel

Actionneur Coupure/limitation/ Protection

Sref

**Fig. 2**

**Fig. 3a**

**Fig. 3b**

**Fig. 4**

**Fig. 5**

**Fig. 6**

Office européen

des brevets

**RAPPORT DE RECHERCHE EUROPEENNE**

Numéro de la demande

EP 08 15 2224

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2002/139575 A1 (FARTASH ARJANG [US] ET AL) 3 octobre 2002 (2002-10-03) * le document en entier * ----- | 1-4,7-9, 11-13 | INV. H05K1/02 |
| Y | EP 1 811 819 A (SIEMENS AG [DE]) 25 juillet 2007 (2007-07-25) * le document en entier * ----- | 1-4,7-9, 11-13 | |
| A | US 5 180 440 A (SIEGEL WILLIAM J [US] ET AL) 19 janvier 1993 (1993-01-19) ----- | | |
| A | DE 41 23 870 A1 (TUTSCH ELLI [DE]) 21 janvier 1993 (1993-01-21) ----- | | |

DOMAINES TECHNIQUES RECHERCHES (IPC)

H05K

Le présent rapport a été établi pour toutes les revendications

| Lieu de la recherche | Date d'achèvement de la recherche | Examinateur |
|---|---|---|
| La Haye | 9 juillet 2008 | Degroote, Bart |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.................................................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 08 15 2224

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

09-07-2008

| Document brevet cité au rapport de recherche | Date de publication | Membre(s) de la famille de brevet(s) | Date de publication |
|---|---|---|---|
| US 2002139575 A1 | 03-10-2002 | AUCUN | |
| EP 1811819 A | 25-07-2007 | AUCUN | |
| US 5180440 A | 19-01-1993 | AUCUN | |
| DE 4123870 A1 | 21-01-1993 | AUCUN | |

EPO FORM P0460

Pour tout renseignement concernant cette annexe : voir Journal Officiel de l'Office européen des brevets, No.12/82

**EP 2 099 264 A1**

**RÉFÉRENCES CITÉES DANS LA DESCRIPTION**

**Documents brevets cités dans la description**

- US 2007090870 A
- US 2004159904 A
- US 2004179576 A